# EUROPEAN PATENT SPECIFICATION

(11) **EP 2 773 170 B1**
(45) Date of publication and mention of the grant of the patent: **05.12.2018**
(21) Application number: 13185898.7
(22) Date of filing: 25.09.2013
(51) Int. Cl.: H05K 7/14, H05K 7/20

(54) **Electronic device with auxiliary assembly structure**
Elektronische Vorrichtung mit zusätzlicher Anordnungsstruktur
Dispositif électronique à structure auxiliaire de montage

(30) Priority: 01.03.2013 CN 201320095544 U
(43) Date of publication of application: 03.09.2014
(73) Proprietor: OMRON Corporation, Shiokoji-dori, Shimogyo-Ku Kyoto-shi Kyoto 600-8530 (JP)
(72) Inventor: Kubo, Masahiko, Kyoto, Kyoto 600-8530 (JP); Ueuchi, Masayuki, Kyoto, Kyoto 600-8530 (JP); Onishi, Hiroyuki, Kyoto, Kyoto 600-8530 (JP); Okada, Kei, Kyoto, Kyoto 600-8530 (JP); Kawano, Hiroki, Kyoto, Kyoto 600-8530 (JP); Kuroko, Masashi, Kyoto, Kyoto 600-8530 (JP); Takatori, Koji, Kyoto, Kyoto 600-8530 (JP); Tanino, Kohei, Kyoto, Kyoto 600-8530 (JP); Minamide, Kenhachiro, Kyoto, Kyoto 600-8530 (JP); Nishida, Masami, Kyoto, Kyoto 600-8530 (JP); Niwa, Hiroki, Kyoto, Kyoto 600-8530 (JP); Marumo, Katsuya, Kyoto, Kyoto 600-8530 (JP)
(74) Representative: Horn Kleimann Waitzhofer Patentanwälte PartG mbB

(56) References cited:
- EP-A1- 2 129 204
- JP-A- 2007 026 854
- JP-A- 2011 159 704

## Description

### BACKGROUND OF THE INVENTION

### TECHNICAL FIELD

The present invention relates to an electronic device with an auxiliary assembly structure, particularly a switching power supply device with an auxiliary assembly structure.

### RELATED ART

In the past, a switching power supply device for industrial purpose is generally formed in such a way that a substrate (i.e., a switching power supply device main body) installed with a heat generating component is assembled in a case. In such switching power supply device, generally, heat dissipation sheets are provided between a heat generating component serving as a heat generating component and the case so that the heat generating component is in effective contact with the case via the heat dissipation sheets to effectively transfer heat to the case for cooling, thereby preventing the switching power supply device from being overheated.

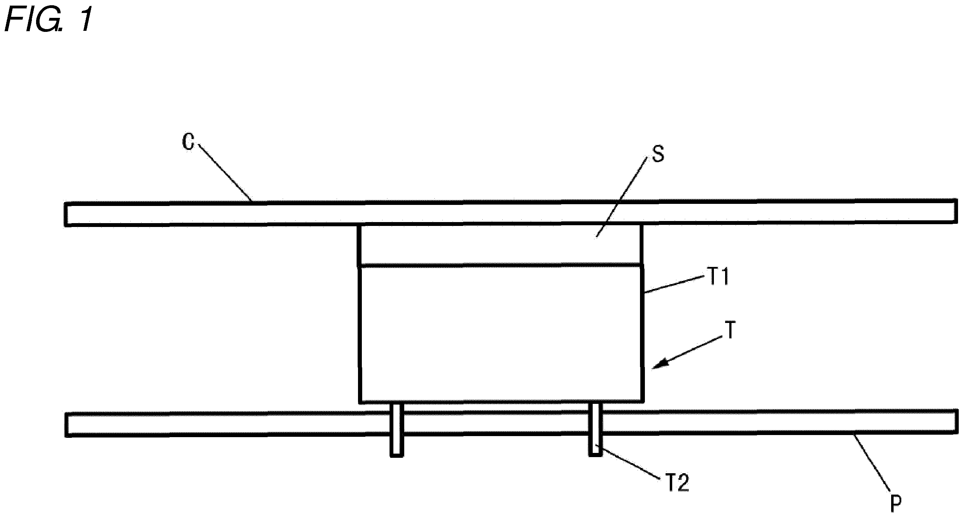

For instance, as shown in a schematic diagram of Fig.1, a transformer T serving as a heat generating component generally includes a transformer main body T1 and transformer pins T2 and is mounted on a substrate P via the transformer pins T2, a lot of heat may be emitted when the transformer T works, the bulk temperature of the substrate P installed with the transformer T will rise if the heat is not dissipated in time, and when the temperature of the substrate P is overhigh, other electronic components may be damaged. In order to prevent the substrate P from being overheated, the main heat generating component (such as the transformer T) configured to heat during working needs to be cooled, and aiming at such problem, in the past, it is general to arrange heat dissipation sheets S between the transformer T serving as the heat generating component and the case C to make the transformer T be in effective contact with the case C via the heat dissipation sheets, thereby cooling the transformer T timely and effectively, and accordingly, reducing the temperature of the whole substrate P.

However, in a traditional sliding inserted-type assembly method where a switching power supply device is formed by assembling a substrate installed with a heat generating component into a case in a transverse sliding manner, the heat dissipation sheets S and the case C are in contact and relatively move, and as the surface of one side of the case C of the heat dissipation sheets S, covering the transformer T, has stickiness or large friction coefficient, the heat dissipation sheets S may deform or may be dislocated relative to the transformer T when the heat dissipation sheets S and the case C relatively move under a contact condition. In the event of the forgoing situation, the transformer T may not be in sufficient contact with the case C to cause that the transformer may be insufficiently cooled. Furthermore, during assembly, as the surface of one side of the case C of the heat dissipation sheets S has stickiness or larger frictional coefficient, the assembling resistance generated during assembly in a transverse sliding manner gets larger and the assembling property gets worse.

In order to solve the technical problems described above, it is general to separate the heat dissipation sheets and the case by a specified distance in the past, so that the case is not in contact with the heat dissipation sheets (or the contact possibility is reduced) in the assembling process, and thus the assembling property is improved while the cooling property is guaranteed. However, it is bound to increase the overall size of the switching power supply device, which goes against miniaturization thereof.
EP 2 129 204 A1 describes a structure for mounting a heat-generating component that includes a circuit board on which a heat-generating component is mounted, a base on which the circuit board is disposed upright, a cover having thermal conductivity, a heat-conductive member electrically isolated from the heat-generating component and a heat transfer plate.
JP 2011 159704 A describes an optical transceiver equipped with a variance-free stable heat dissipating mechanism by effectively achieving thermal coupling between a heat generating component having unevenness on an external surface and a slidably-fitted metallic cover, wherein the optical transceiver is configured such that the outer side of a circuit board on which an electronic component group performing photoelectric conversion and transmission and reception of electric signals is mounted is covered with slide-fitting of the metallic cover.

### SUMMARY

The present invention has been devised to solve the problems described above, and an object thereof is to provide an electronic device with an auxiliary assembly structure, which can improve the assembling property when an electronic device main body installed with a heat generating component, covered by a heat dissipation sheet, is assembled into the case in a transverse sliding manner, while guaranteeing the cooling function of the heat dissipation sheet.

In accordance with one aspect of the present invention, the electronic device with the auxiliary assembly structure includes a case and an electronic device main body that is inserted into the case, the electronic device main body comprising: a substrate, a heat generating component which comprises a heat generating component main body and mounting pins and is mounted on the substrate via the mounting pins, and a heat dissipation sheet provided on a part of the heat generating component main body that faces the case and/or a part of the mounting pins that faces the case.

The auxiliary assembly structure is a cover sheet which is provided between the heat dissipation sheet and the case and of which the friction coefficient is smaller than that of the heat dissipation sheet, and at least one opening is formed in the cover sheet at a position covering the heat dissipation sheet, and a peripheral part surrounding the opening is in contact with the heat dissipation sheet.

According to the invention described above, the "cover sheet" is a sheet of which the friction coefficient is smaller than that of the heat dissipation sheet, and when the cover sheet is provided between the heat dissipation sheet and the case, the electronic device may be mounted in the case more smoothly compared with the electronic device without the cover sheet.

In addition, the cover sheet preferably includes a front piece, a back piece and a connecting piece connecting the front and back pieces, the front piece covers a surface of the substrate on which the heat generating component is mounted, and the back piece covers a back surface of the substrate opposite to the surface on which the heat generating component is mounted.

In addition, a first side plate and a second side plate are preferably provided at two opposite ends of the substrate, the first side plate and the second side plate facing each other, a first bending part is formed by bending and extending an end part of the back piece towards the surface of the substrate, the end part of the cover sheet is in the side of the first side plate, and claw parts configured to be engaged with the first side plate are formed on the first bending part, a second bending part is formed by bending and extending an end part of the back piece towards the surface of the substrate, the end part of the back piece is in the side of the second side plate, the extended end of the second bending part is further bent towards a direction parallel to the surface of the substrate and extended to form a third bending part, the extension end of the third bending part is connected with the front piece, the front and back pieces connecting part is formed by the second bending part and the third bending part, and a cut-in part configured to be engaged with a cutout part formed on the second side plate is formed on a position of the third bending part corresponding to the second side plate.

In addition, the heat dissipation sheet may be provided on the part of the mounting pins facing the case, and the cover sheet covers the back surface of the substrate opposite to the surface on which the heat generating component is mounted.

In addition, a first side plate and a second side plate are preferably provided on two opposite ends of the substrate, the first side plate and the second side plate facing each other, a first bending part is formed by bending and extending an end part of the cover sheet towards the surface of the substrate, the end part of the cover sheet is in the side of the first side plate, and claw parts configured to be engaged with the first side plate are formed on the first bending part, and a second bending part is formed by bending and extending an end part of the back piece towards the surface of the substrate, the end part of the cover sheet is in the side of the second side plate, and a cut-in part configured to be engaged with cutouts part formed on the substrate is formed on the second bending part.

In addition, an insulating sheet is preferably employed as the cover sheet. Furthermore, preferably, a switching power supply device is employed as the electronic device, and a transformer is employed as the heat generating component.

Based on a fact that the cover sheet is mounted in a manner of covering from the periphery of the substrate installed with the heat generating component to insert the substrate on which the cover sheet covers into the case, the heat dissipation sheet which may have stickiness and cover the heat generating component, such as the transformer, provided on the substrate can be prevented from coming into direct contact with the case, thereby preventing the heat dissipation sheet from deforming and dislocating during assembling, and meanwhile, the assembling resistance can be reduced and the assembling property is improved when the substrate installed with the heat generating component is inserted and assembled in the case. Therefore, the assembling property between the substrate installed with the heat generating component and the case can be improved while the cooing function of the heat dissipation sheet is guaranteed. In addition, as the openings are provided, the cooling property can be guaranteed while the assembling property is ensured.

### BRIEF DESCRIPTION OF THE DRAWINGS

Fig. 1 is a schematic view showing a status that a conventional substrate installed with a transformer is assembled in the case;
Fig. 2 is a perspective view of the auxiliary assembly structure according to comparative embodiment 1;
Fig. 3 is a front view of the auxiliary assembly structure according to comparative embodiment 1;
Fig.4 is a rear view of the auxiliary assembly structure according to comparative embodiment 1;
Fig. 5 is a left view of the auxiliary assembly structure according to comparative embodiment 1;
Fig. 6 is a right view of the auxiliary assembly structure according to comparative embodiment 1;
Fig. 7 is a top view of the auxiliary assembly structure according to comparative embodiment 1;
Fig. 8 is a bottom view of the auxiliary assembly structure according to comparative embodiment 1;
Fig. 9 is an assembly schematic view of the auxiliary assembly structure according to comparative embodiment 1;
Fig. 10 is a perspective view of the auxiliary assembly structure according to embodiment 2;
Fig. 11 is a schematic view of a status that the substrate installed with the transformer is assembled in the case via the auxiliary assembly structure according to embodiment 3;
Fig. 12 is a perspective view of the auxiliary assembly structure according to embodiment 3;
Fig. 13 is an assembly schematic view of the auxiliary assembly structure according to embodiment 3; and
Fig. 14 is a perspective view of the case of the switching power supply device.

### DETAILED DESCRIPTION

### Comparative embodiment 1

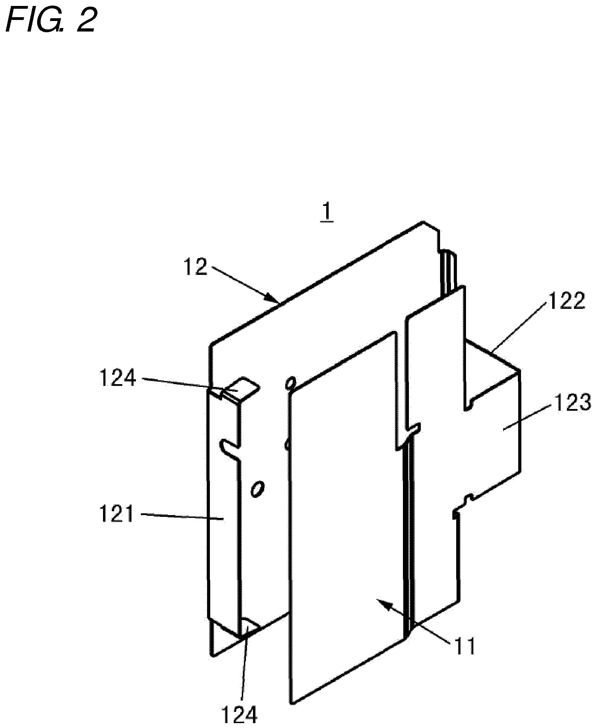

With reference to Figs. 2 to 9 described below, comparative embodiment 1 of the electronic device with the auxiliary assembly structure, which is an example useful for understanding the invention, is described below.

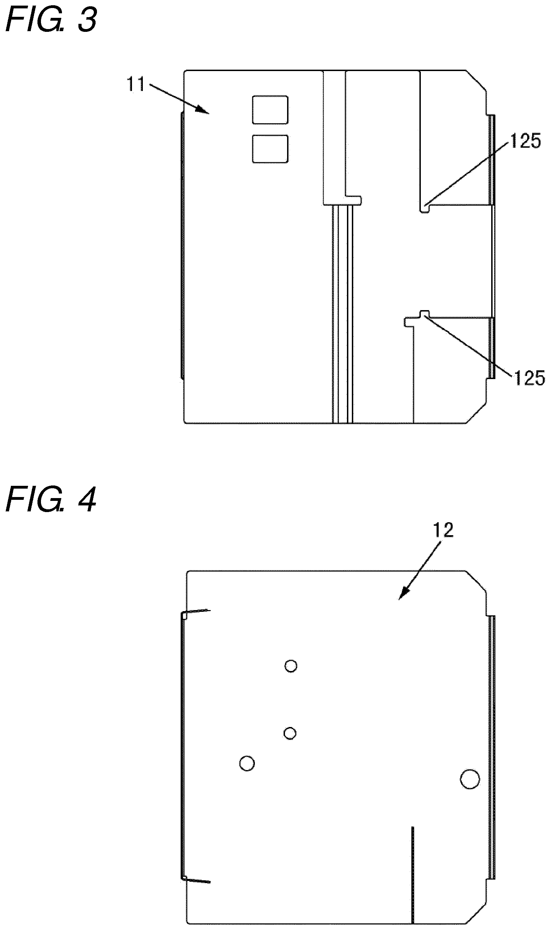

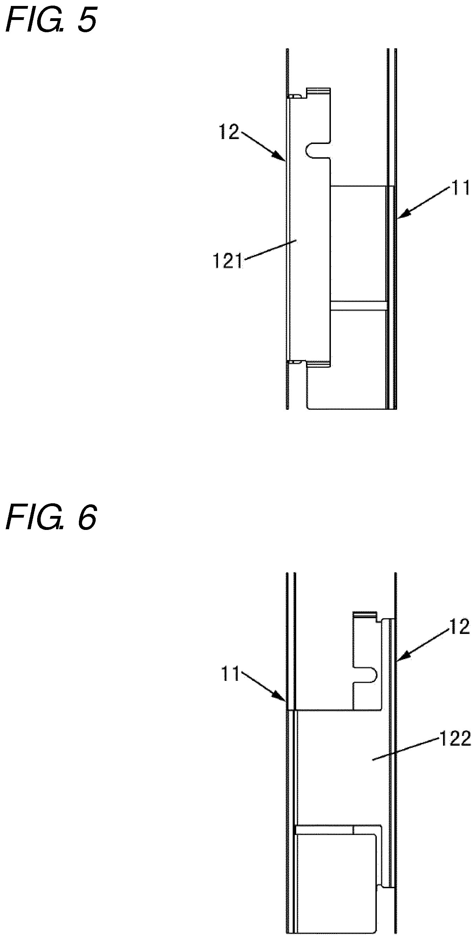

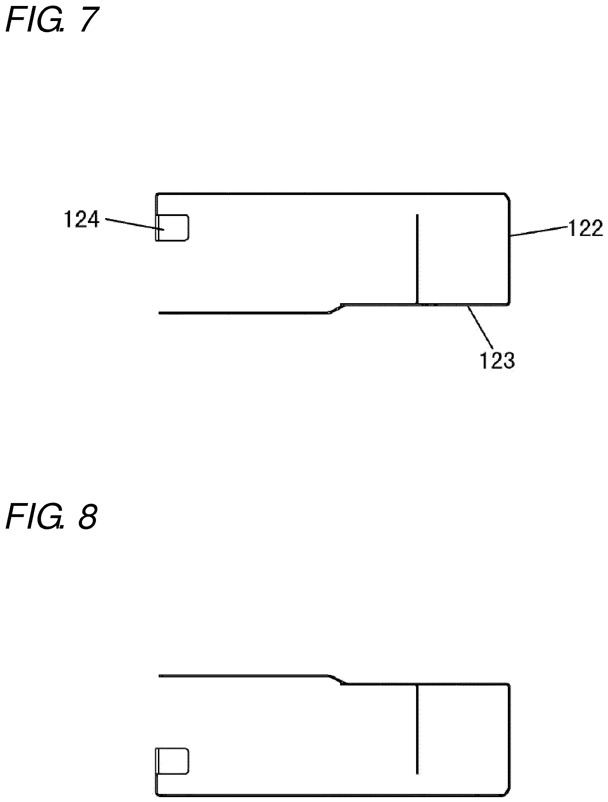

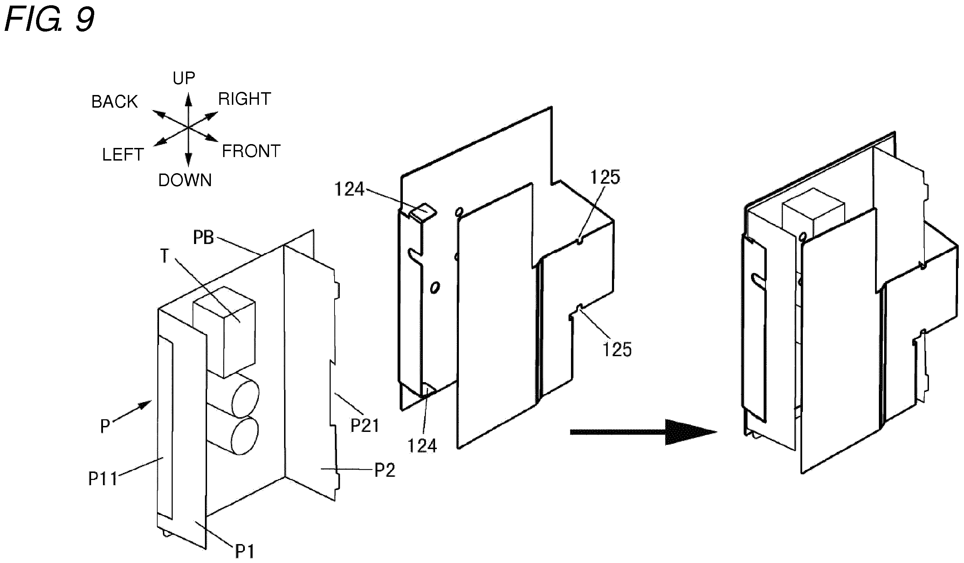

Fig. 2 is a perspective view of the auxiliary assembly structure according to comparative embodiment 1. Fig. 3 is a front view of the auxiliary assembly structure according to comparative embodiment 1. Fig. 4 is a rear view of the auxiliary assembly structure according to comparative embodiment 1. Fig. 5 is a left view of the auxiliary assembly structure according to comparative embodiment 1. Fig. 6 is a right view of the auxiliary assembly structure according to comparative embodiment 1. Fig. 7 is a top view of the auxiliary assembly structure according to comparative embodiment 1. Fig. 8 is a bottom view of the auxiliary assembly structure according to comparative embodiment 1. Fig. 9 is an assembly schematic view of the auxiliary assembly structure according to comparative embodiment 1. In addition, in Fig. 9, front, back, left, right, up and down directions are defined with arrows for illustrative purposes.

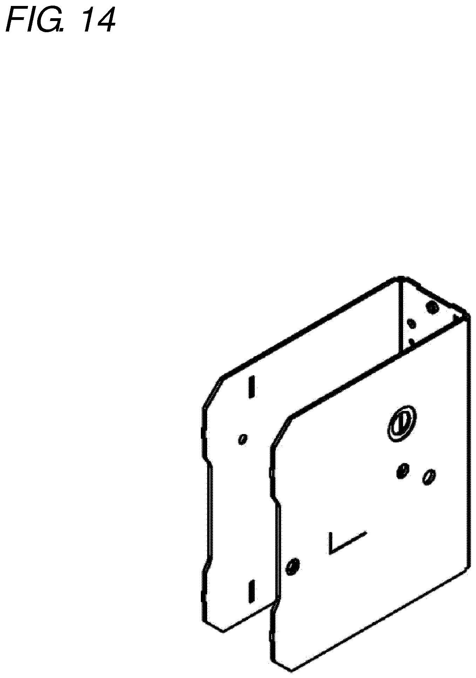

With reference to Fig. 9, the electronic device is formed in such a way that the electronic device main body is inserted into the case in a sliding manner (refer to Fig. 14), and the electronic device main body includes a substrate, a heat generating component that includes a heat generating component main body and mounting pins and is provided on the substrate via the mounting pins, and one or more heat dissipation sheets that are provided on a part or parts of the heat generating component main body facing the case, and/or on a part or parts of the mounting pins facing the case. In this embodiment, a switching power supply device is given as an example of the electronic device, and a transformer T is given as an example of the heat generating component. In addition, the auxiliary assembly structure is a cover sheet 1 which covers approximately the entire body of the electronic device main body. The electronic device main body is inserted into the case (not shown in the figure) in a sliding manner under the condition that the electronic device main body is covered by the cover sheet 1. The "heat dissipation sheet" may be made of an insulating material that is suitable for dissipating heat. For example, it may be made of a gel sheet, such as a silicone gel sheet, for example. The "cover sheet" is a sheet of which the frictional coefficient is smaller than that of the heat dissipation sheets, and the electronic device can be mounted in the case more smoothly when the cover sheet is provided between the heat dissipation sheets and the case. The cover sheet may be made of a plastic material, such as polypropylene. However, there is no limitation to these materials.

As shown in Fig. 9, a substrate P includes: a bottom substrate PB; a side cooling component P1 which is vertical to the bottom substrate PB and connected with one end (the left end in Fig. 9) of the bottom substrate PB; and a side substrate P2 which is vertical to the bottom substrate PB and connected with an inside part of the other end (the right end in Fig. 9), opposite to the abovementioned end, of the bottom substrate PB. An elongated cutout P11 which extends along one end of the bottom substrate PB is provided on one side of the side cooling component P1 connected with the bottom substrate PB. In addition, an elongated cutout P21 which extends along one side of the side substrate P2 opposite to the abovementioned side, is provided on one side of the side substrate P2 opposite to the abovementioned side connected with the bottom substrate PB.

In addition, as shown in Figs. 2 to 9, the cover sheet 1 includes a front piece 11 and a back piece 12, wherein the front piece 11 covers the upper surface of the heat generating component (such as the transformer T) provided on the bottom substrate PB of the substrate P, that is, the front piece 11 generally covers the surfaces of the heat dissipation sheets, and the back piece 12 covers the back surface, opposite to a surface on which the heat generating component is mounted, of the bottom substrate PB.

A first bending part 121 is formed by bending and extending the end part of the side cooling component P1 side of the back piece 12 towards the surface of the bottom substrate PB (a surface configured to install the heat generating component), the shape of the first bending part 121 corresponds to that of the cutout P11 provided on the side cooling component P1, and the extension direction of the first bending part 121 is in accordance with that of the side cooling component P1. A claw part 124 is respectively provided on each of two ends of the first bending part 121 (the upper end and the lower end in Fig. 9), and the claw parts 124 are engaged with the upper end part and the lower end part of the cutout P11 of the side cooling component P1 in a vertical direction.

A second bending part 122 is formed by bending and extending the end part of the side substrate P2 side of the back piece 12 towards the surface of the bottom substrate PB (a surface configured to realize the installation of the heat generating component), the extension end of the second bending part 122 is further bent to extend in a direction parallel to the bottom substrate PB to form a third bending part 123, and the extension end of the third bending part 123 is connected with the front piece 11.

In addition, forming positions as well as widths in the vertical direction, of the second bending part 122 and the third bending part 123, correspond to a cutout P21 provided on the side substrate 2. A cut-in part 125 is respectively provided at each of two ends in the vertical direction, on a position of the third bending part 123 corresponding to the cutout P21, and the cut-in parts are engaged with the upper end and the lower end of the cutout P21 positioned on the side substrate P2.

These facts show a specific structure of the cover sheet 1 serving as the auxiliary assembly structure according to comparative embodiment 1, and a mounting method of the cover sheet 1 is illustrated below with reference to Fig. 9. The cover sheet 1 is configured to be used in a manner of covering the electronic device main body. The cover sheet 1 is made of a flexible material, and thus, in the mounting process, the front piece 11 and the back piece 12 are opened towards a direction, in which the front piece 11 and the back piece are separated, from the first bending part 121 of the front piece 11 and the back piece 12, then the substrate P installed with the heat generating component is inserted between the front piece 11 and the back piece 12, so that the claw parts 124 provided on the first bending part 121 are engaged with the upper end and the lower end of the cutout P11 on the side cooling component P1 of the substrate P in a vertical direction, and further, the cut-in parts 125 provided on the third bending part 123 are engaged with the upper end and the lower end of the cutout P21 on the side substrate P2. Accordingly, the cover sheet 1 is fixed on the substrate P.

As the cover sheet 1 is mounted in a manner of covering from the periphery of the electronic device main body and the electronic device main body covered with the cover sheet 1 is inserted into the case, the heat dissipation sheets are prevented from coming into direct contact with the case, wherein the heat dissipation sheets have stickiness and cover the heat generating component such as the transformer T provided on the substrate P(refer to Fig. 9), thereby preventing the heat dissipation sheets from deforming and dislocating in the assembling process, and meanwhile, the assembling resistance can be reduced and the assembling property can be improved when the electronic device main body is inserted and assembled in the case. Thus, the assembling property between the electronic device main body and the case can be improved while the cooling function of the heat dissipation sheets is guaranteed.

### Embodiment 2

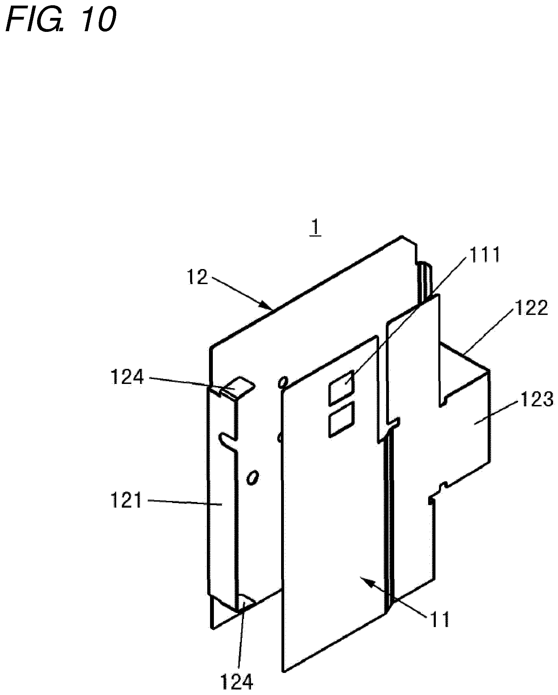

Embodiment 2 of the present invention is described below. Fig. 10 is a perspective view of the auxiliary assembly structure according to embodiment 2. According to embodiment 2, a constituent element identical with or similar to the auxiliary assembly structure according to comparative embodiment 1 is marked with the same drawing sign, and the description thereof is omitted.

According to embodiment 2, openings are provided on a position of the cover sheet serving as the auxiliary assembly structure corresponding to the heat generating component. As shown in Fig. 10, the openings 111 are provided on a position, corresponding to the transformer T, on the front piece 11 of the cover sheet 1, and therefore, the cooling property of the transformer T is improved.

In this embodiment, two openings 111 are provided and are respectively positioned in a range which is in contact with the heat dissipation sheets covering the transformer T, that is, the peripheral part of the cover sheet 1 is in contact with the heat dissipation sheets, and two openings 111 are provided inside the cover sheet. Therefore, as the cover sheet is provided on at least local part between the heat dissipation sheets covering the transformer T and the case, the substrate installed with the transformer T can be assembled in the case against the influence of the heat dissipation sheets covering the transformer T which have stickiness, and the assembling property between the substrate installed with the heat generating component and the case is improved. Further, as the openings 111 are formed in a range, which is in contact with the cooing fins covering the transformer T, on the cover sheet 1, heat can be directly transferred to the case without passing through the cover sheet within at least local range, and thus favorable cooling property can also be guaranteed.

In addition, through tests, it is detected that the temperature of the transformer T can be reduced by about 15-20°C as the openings 111 are provided, so that the ambient temperature thereof can be reduced by about 5°C.

### Embodiment 3

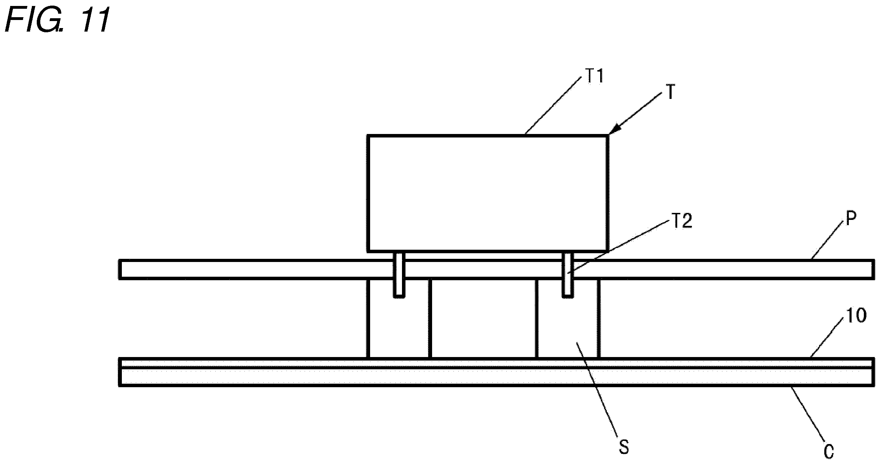

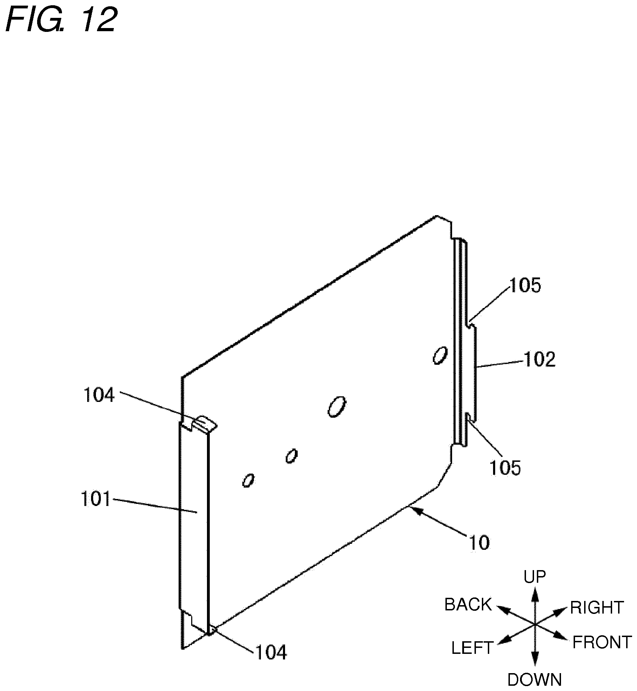

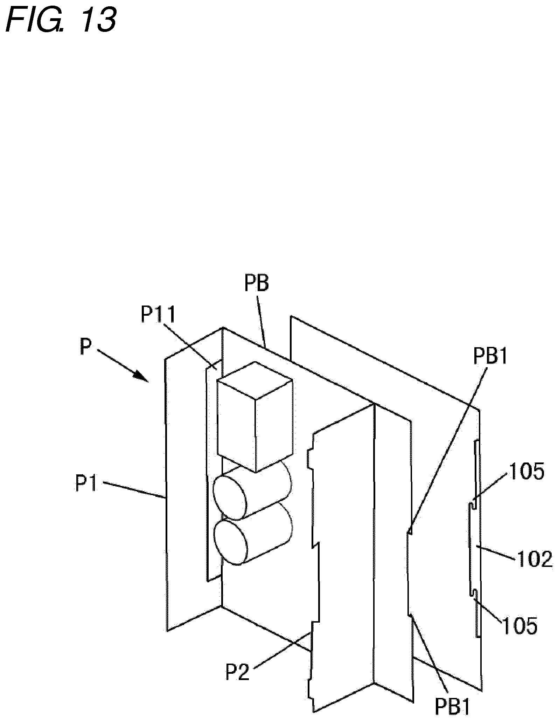

Embodiment 3 of the present invention is described below. Fig. 11 is a schematic view showing a status that the substrate installed with the transformer is assembled in the case via the auxiliary assembly structure according to embodiment 3. Fig. 12 is a perspective view of the auxiliary assembly structure according to embodiment 3. Fig. 13 is an assembly schematic view of the auxiliary assembly structure according to embodiment 3. According to embodiment 3, a constituent element identical with or similar to the auxiliary assembly structure in comparative embodiment 1 or embodiment 2 is marked with the same drawing sign, and the description thereof is omitted. In addition, the front, back, left, right, up and down directions are defined with arrows in Fig.12 for illustrative purposes.

In the prior art, cooling is carried out generally from the surface of a transformer main body T1, however, as shown in Fig. 11, the heat dissipation sheets S may also be provided between the transformer pins T2 of the transformer T and the case C so as to carry out cooling from the transformer pins T2. That is, the transformer T is mounted on a substrate P via the transformer pins T2, which pass through the substrate P and protrude out from the back surface of the substrate P, the heat dissipation sheets S are provided between the transformer pins T2 protruding out of the back surface of the substrate P and the case C, and thus cooling is carried out on the transformer T from the transformer pins T2.

Under the circumstance as described above, as the heat dissipation sheets are provided between the transformer pins T2 and the case C, when the substrate P installed with the heat dissipation sheets S in this way is assembled in the case C, the heat dissipation sheets covering the back surface of the substrate P come into contact with the case C, likewise, the problem that the heat dissipation sheets S deform or dislocate when being assembled into the case in a transverse sliding manner is caused since the surface of one side of the case C of the heat dissipation sheets S has stickiness or large friction coefficient, and moreover, the problem that the assembling property gets worse as the assembling resistance gets larger is also caused when the heat dissipation sheets are in contact with the case.

Hence, according to embodiment 3 of the present invention, as shown in Figs. 11 to 13, the cover sheet 10 that serves as the auxiliary assembly structure covers the back surface (the reverse side of the installation surface of the heat generating component) of the substrate P installed with the heat generating component. The substrate P is assembled in the case C under the condition that the back surface thereof is covered by the cover sheet 10.

As shown in Fig. 13, the substrate P, as in comparative embodiment 1, includes: a bottom substrate PB; a side cooling component P1 which is vertical to the bottom substrate PB and connected with one end of the bottom substrate PB; and a side substrate P2 which is vertical to the bottom substrate PB and is connected with an inside part of the other end opposite to the abovementioned end of the bottom substrate PB. An elongated cutout P11 which extends along one end of the bottom substrate PB is provided on one side of the side cooling component P1 connected with the bottom substrate PB. In addition, an elongated cutout PB1 which extends along the other end of the bottom substrate PB is provided on the other end, opposite to the abovementioned end, of the bottom substrate PB.

As shown in Figs. 11 to 13, the cover sheet 10 covers a back surface of the bottom substrate PB, wherein the back surface is a reverse side of the surface on which the heat generating component is installed.

A first bending part 101 is formed by bending and extending the end part of the side cooling component P1 side of the cover sheet 10 towards the surface (a surface on which the heat generating component is mounted) of the bottom substrate PB, the shape of the first bending part 101 corresponds to that of the cutout P11 on the side cooling component P1, and in addition, the extension direction of the first bending part 101 is in accordance with that of the side cooling component P1. A claw part 104 is respectively formed at each of two ends (the upper end and the lower end in Fig. 12) of the first bending part 101, and the claw parts 104 are engaged with the upper end and the lower end of the cutout P11 of the side cooling component P1 in a vertical direction.

A second bending part 102 is formed by bending and extending the end part of the side substrate P2 of the cover sheet 10 towards the surface of the bottom substrate PB (a surface on which the heat generating component is mounted). The forming position and width in a vertical direction of the second bending part 102, correspond to a cutout PB1 provided on the other end, opposite to one end, of the bottom substrate PB. A cut-in part 105 is provided at each of two ends of a position, corresponding to the cutout PB1, of the second bending part in a vertical direction, and the cut-in parts 105 are engaged with two ends of the cutout PB1 on the bottom substrate PB in a length direction.

These facts show a specific structure of the cover sheet 10 serving as the auxiliary assembly structure according to embodiment 3, and a mounting method of the cover sheet 10 is illustrated below with reference to Fig. 13. The cover sheet 10 is configured to be used in a manner of covering the back surface of the substrate P installed with the heat generating component. In the mounting process, the cover sheet 10 covers the back surface of the substrate P to which the heat dissipation sheets are attached, the claw parts 104 provided on the first bending part 101 are engaged with two ends, of the cutout P11 on the side cooling component P1 of the substrate P in a vertical direction, and the cut-in parts 105 provided on the second bending part 102 are engaged with two ends of the cutout PB1 on the bottom substrate PB in a vertical direction. Thus, the cover sheet 10 is fixed on the substrate P.

As the cover sheet 10 is mounted by covering from the back surface of the substrate P installed with the heat generating component and the substrate P covered with the cover sheet 10 is inserted into the case, the heat dissipation sheets which have stickiness and cover the back surface of the substrate P can be prevented from being in direct contact with the case, thereby preventing the heat dissipation sheets from deforming and dislocating, and meanwhile, the assembling resistance can be reduced and the assembling property can be improved when the substrate P installed with the heat generating component is inserted and assembled in the case. Therefore, the assembling property between the substrate installed with the heat generating component and the case can be improved while the cooling function of the heat dissipation sheets is guaranteed.

### Other embodiments

The present utility mode is not limited to structures of the cover sheet according to the embodiments described above, and it can be implemented as long as the cover sheet is mounted between the heat dissipation sheets with stickiness and the case. Preferably, according to the present invention, the cover sheet is an insulating sheet so that insulation between the substrate and the case can be realized to ensure safety use of the switching power supply device.

In addition, in the embodiments described above, the cover sheet covers the whole substrate, but not limited thereto, and can only cover the heat generating component installed with the heat dissipation sheets.

In addition, in the embodiments described above, two openings are provided on a part, corresponding to the heat generating component of the cover sheet, but not limited thereto, one or more than one openings can also be provided, and the number of the openings can be freely set in accordance with the size of the heat generating component. However, under the circumstance that only one opening is formed, if the area of the opening is large and the cover sheet is thin, the heat dissipation sheets with stickiness are possible to adhere with the case via the opening, and thus more than two openings are preferred to form. Further, the openings can also be provided according to embodiment 3.

In addition, in the embodiments described above, the cover sheet may be integrally formed via punching.

In addition, in the embodiments described above, the heat generating component is not limited to the transformer and may also be any heat generating component.

In addition, in the embodiments described above, the substrate includes the bottom substrate, the side cooling component and the side substrate, but not limited thereto, and may be configured just by including a bottom substrate, a first side plate and a second side plate, or only including a bottom substrate.

In addition, in the embodiments described above, a structure that the heat dissipation sheets cover the upper surface of the heat generating component or the mounting pins of the heat generating component is enumerated, however, a structure that the heat dissipation sheets simultaneously cover the upper surface of the heat generating component and the mounting pins may also be adopted, and cooling is carried out on the substrate by covering the whole substrate.

In addition, the abovementioned description shows that the heat dissipation sheets have stickiness, but not limited thereto, the heat dissipation sheets may not have stickiness yet, and the technical problem mentioned by this application occurs just when the friction coefficient of each heat dissipation sheet is large.

In addition, the cover sheet may be a polycarbonate film and may be made from a silicon compound or a silica gel compound.

The preferred embodiments of the present invention are as described above, however, the present invention is not limited to these embodiments specifically disclosed and can be subjected to various transformations or alternations as long as not go beyond the scope of claims.

## Claims

1. An electronic device with an auxiliary assembly structure (1, 10), formed by slidingly inserting an electronic device main body into a case (C), the electronic device main body comprising:
a substrate (P),
a heat generating component (T) comprising a heat generating component main body (T1) and mounting pins (T2), the heat generating component main body (T1) being mounted on the substrate (P) via the mounting pins (T2), and
a heat dissipation sheet (S) that is provided on a part of the heat generating component main body (T1) that faces the case (C), and/or a part of the mounting pins (T2) that faces the case (C), wherein
the auxiliary assembly structure (1, 10) is a cover sheet (1, 10) being provided between the heat dissipation sheet (S) and the case (C) and having a smaller frictional coefficient than that of the heat dissipation sheet (S), and
at least one opening is formed in the cover sheet (1, 10) at a position covering the heat dissipation sheet (S) so that heat can be directly transferred from the heat dissipation sheet (S) to the case (C), and a peripheral part surrounding the opening is in contact with the heat dissipation sheet (S).

2. The electronic device with the auxiliary assembly structure (1, 10) according to claim 1, wherein
the cover sheet (1, 10) comprises a front piece (11), a back piece (12), and a connecting part connecting the front and back pieces (11, 12),
the front piece (11) covers the surface of the substrate (P) on which the heat generating component (T) is mounted, and
the back piece (12) covers the back surface of the substrate (P) opposite to the surface on which the heat generating component (T) is mounted.

3. The electronic device with the auxiliary assembly structure (1, 10) according to claim 2, wherein
a first side plate and a second side plate are provided at two opposite ends of the substrate (P), the first side plate and the second side plate facing each other,
a first bending part (121) is formed by bending and extending an end part of the back piece (12) towards the surface of the substrate (P) the end part of the back piece (12) is in the side of the first side plate, and claw parts configured to be engaged with the first side plate are formed on the first bending part (121),
a second bending part (122) is formed by bending and extending an end part of the back piece (12) towards the surface of the substrate (P), the end part of the back piece (12) is in the side of the second side plate, the extended end of the second bending part is further bent towards a direction parallel to the surface of the substrate (P) and extended to form a third bending part (123), the third bending part (123) is connected with the front piece (11), and the front and back pieces connecting part is formed by the second bending part and the third bending part (123), and
a cut-in part (105) configured to be engaged with a cutout part formed on the second side plate is formed at a position of the third bending part (123) corresponding to the second side plate.

4. The electronic device with the auxiliary assembly structure (1, 10) according to any of claims 1 to 4, wherein
the heat dissipation sheet (S) is provided on the part of the mounting pins (T2) that faces the case (C), and the cover sheet (1, 10) covers the back surface of the substrate (P) opposite to the surface on which the heat generating component (T) is mounted.

5. The electronic device with the auxiliary assembly structure (1, 10) according to claim 4, wherein
a first side plate and a second side plate are provided at two opposite ends of the substrate (P), the first side plate and the second side plate facing each other;
a first bending part (121) is formed by bending and extending an end part of the cover sheet (1, 10) towards the surface of the substrate (P), the end part of the cover sheet (1, 10) is in the side of the first side plate claw parts configured to be engaged with the first side plate are formed on the first bending part (121), and
a second bending part (122) is formed by bending and extending an end part of the cover sheet (1, 10) towards the surface of the substrate (P), the end part of the cover sheet (1, 10) is in the side of the second side plate and a cut-in part (105) configured to be engaged with a cutout part formed on the substrate (P) is formed on the second bending part (122).

6. The electronic device with the auxiliary assembly structure (1, 10) according to claims 1 to 5, wherein
the cover sheet (1, 10) is an insulating sheet.

7. The electronic device with the auxiliary assembly structure (1, 10) according to claims 1 to 5, wherein
the electronic device is a switching power supply device and the heat generating component (T) is a transformer.

## Patentansprüche

1. Elektronische Vorrichtung mit einer Zusammenbauunterstützungsstruktur (1, 10), wobei die elektronische Vorrichtung durch gleitendes Einsetzen eines elektronischen Vorrichtungshauptteils in ein Gehäuse (C) gebildet ist, wobei der elektronische Vorrichtungshauptteil aufweist:
ein Substrat (P),
eine Wärmeerzeugungskomponente (T), die ein Wärmeerzeugungskomponenten-Hauptteil (T1) und Montagestifte (T2) aufweist, wobei der Wärmeerzeugungskomponenten-Hauptteil (T1) auf dem Substrat (P) über die Montagestifte (T2) montiert ist, und
ein Wärmedissipationsblech (S), das auf einem Teil des Wärmeerzeugungskomponenten-Hauptteil (T1) vorgesehen ist, der dem Gehäuse (C) gegenüberliegt und/oder einem Teil der Montagestifte (T2), die dem Gehäuse (C) gegenüberliegen, wobei
die Zusammenbauunterstützungsstruktur (1, 10) ein Abdeckblech (1, 10) ist, das zwischen dem Wärmedissipationsblech (S) und dem Gehäuse (C) vorgesehen ist und einen kleineren Reibungskoeffizienten aufweist als jener des Wärmedissipationsblechs (S), und
zumindest eine Öffnung in dem Abdeckblech (1, 10) an einer Position gebildet ist, die das Wärmedissipationsblech (S) bedeckt, so dass Wärme direkt von dem Wärmedissipationsblech (S) an das Gehäuse (C) übertragen werden kann und ein Umgebungsabschnitt, der die Öffnung umgibt, in Kontakt mit dem Wärmedissipationsblech (S) ist.

2. Elektronische Vorrichtung mit Zusammenbauunterstützungsstruktur (1, 10) gemäß Anspruch 1, wobei
das Abdeckblech (1, 10) ein vorderes Stück (11), ein hinteres Stück (12) und einen Verbindungabschnitt aufweist, der das vordere und das hintere Stück (11, 12) verbindet,
wobei das vordere Stück (11) die Oberfläche des Substrats (P) bedeckt, auf welchem die Wärmeerzeugungskomponente (T) montiert ist, und
wobei das hintere Stück (12) die hintere Oberfläche des Substrats (P) gegenüber der Oberfläche, auf welcher die Wärmeerzeugungskomponente (T) montiert ist, bedeckt.

3. Elektronische Vorrichtung mit Zusammenbauunterstützungsstruktur (1, 10) gemäß Anspruch 2, wobei
eine erste Seitenplatte und eine zweite Seitenplatte an zwei gegenüberliegenden Enden des Substrats (P) vorgesehen sind, wobei sich die erste Seitenplatte und die zweite Seitenplatte einander gegenüberliegen,
ein erster gebogener Abschnitt (121) durch Biegen und Verlängern eines Endabschnitts des hinteren Stücks (12) in Richtung der Oberfläche des Substrats (P) gebildet ist, das Ende des hinteren Stücks (12) in die Seite der ersten Seitenplatte ist und Klammerabschnitte, die eingerichtet sind, in die erste Seitenplatte einzugreifen, auf dem ersten Biegeabschnitt (121) gebildet sind,
ein zweiter Biegeabschnitt (122) durch Biegen und Verlängern eines Endabschnitts des hinteren Stücks (12) in Richtung der Oberfläche des Substrats (P) gebildet ist, das Ende des hinteren Stücks (12) in der Seite der zweiten Seitenplatte ist, das verlängerte Ende des zweiten Biegeabschnitts weiter in eine Richtung parallel zu der Oberfläche des Substrats (P) gebogen und verlängert ist, um einen dritten Biegeabschnitt (123) zu bilden, wobei der dritte Biegeabschnitt (123) mit dem vorderen Stück (11) verbunden ist und der das vordere und hintere Stück verbindende Abschnitt durch den zweite Biegeabschnitt und den dritten Biegeabschnitt (123) gebildet ist, und
ein eingeschnittener Abschnitt (105), der eingerichtet ist, mit einem ausgeschnittenen Abschnitt einzugreifen, der auf der zweiten Seitenplatte an einer Position des dritten Biegeabschnitts (123) gebildet ist, die der zweiten Seitenplatte entspricht.

4. Elektronische Vorrichtung mit Zusammenbauunterstützungsstruktur (1, 10) gemäß einem der Ansprüche 1 bis 4, wobei
das Wärmedissipationsblech (S) auf dem Abschnitt der Montagestifte (T2) vorgesehen ist, der dem Gehäuse (C) gegenüberliegt, und das Abdeckblech (1, 10) die hintere Oberfläche des Substrats (P) gegenüber der Oberfläche bedeckt, auf welcher die Wärmeerzeugungskomponente (T) montiert ist.

5. Elektronische Vorrichtung mit Zusammenbauunterstützungsstruktur (1, 10) gemäß Anspruch 4, wobei
eine erste Seitenplatte und eine zweite Seitenplatte an zwei gegenüberliegenden Enden des Substrats (P) vorgesehen sind, wobei sich die erste Seitenplatte und die zweite Seitenplatte einander gegenüberliegen;
ein erster Biegeabschnitt (121) durch Biegen und Verlängern eines Endabschnitts des Abdeckblechs (1, 10) in Richtung der Oberfläche des Substrats (P) gebildet ist, wobei das Ende des Abdeckblechs (1, 10) in der Seite der ersten Seitenplatte ist, wobei Klammerabschnitte, die eingerichtet sind, mit der ersten Seitenplatte einzugreifen, auf dem ersten Biegeabschnitt (121) gebildet sind; und
ein zweiter Biegeabschnitt (122) durch Biegen und Verlängern eines Endabschnitts des Abdeckblechs (1, 10) in Richtung der Oberfläche des Substrats (P) gebildet ist, wobei der Endabschnitt des Abdeckblechs (1, 10) auf der Seite der zweiten Seitenplatte ist, und ein eingeschnittener Abschnitt (105), der eingerichtet ist, mit einem ausgeschnittenen Abschnitt einzugreifen, der auf dem Substrat (P) gebildet ist, auf dem zweiten Biegeabschnitt (122) gebildet ist.

6. Elektronische Vorrichtung mit Zusammenbauunterstützungsstruktur (1, 10) gemäß Anspruch 1 bis 5, wobei das Abdeckblech (1, 10) ein isolierendes Blech ist.

7. Elektronische Vorrichtung mit Zusammenbauunterstützungsstruktur (1, 10) gemäß einem der Ansprüche 1 bis 5, wobei
die elektronische Vorrichtung eine Schaltnetzteilvorrichtung ist und die Wärmeerzeugungskomponente (T) ein Transformator ist.

## Revendications

1. Dispositif électronique doté d'une structure auxiliaire d'assemblage (1, 10), formée par introduction coulissante d'un corps principal de dispositif électronique dans un boîtier (C), le corps principal de dispositif électronique comprenant :
un substrat (P),
un composant de génération de chaleur (T) comprenant un corps principal (T1) de composant de génération de chaleur et des broches de montage (T2), le corps principal (T1) de composant de génération de chaleur étant monté sur le substrat (P) par le biais des broches de montage (T2), et
une feuille de dissipation de chaleur (S) qui est disposée sur une partie du corps principal (T1) de composant de génération de chaleur qui fait face au boîtier (C), et/ou sur une partie des broches de montage (T2) qui fait face au boîtier (C), dans lequel
la structure auxiliaire d'assemblage (1, 10) est une feuille de recouvrement (1, 10) disposée entre la feuille de dissipation de chaleur (S) et le boîtier (C) et ayant un coefficient de friction inférieur à celui de la feuille de dissipation de chaleur (S), et
au moins une ouverture est formée dans la feuille de recouvrement (1, 10) à une position recouvrant la feuille de dissipation de chaleur (S) de façon à pouvoir transférer directement de la chaleur de la feuille de dissipation de chaleur (S) vers le boîtier (C), et une partie périphérique entourant l'ouverture est en contact avec la feuille de dissipation de chaleur (S).

2. Dispositif électronique doté de la structure auxiliaire d'assemblage (1, 10) selon la revendication 1, dans lequel
la feuille de recouvrement (1, 10) comprend une pièce avant (11), une pièce arrière (12), et une partie de liaison reliant les pièces avant et arrière (11, 12),
la pièce avant (11) recouvre la surface du substrat (P) sur laquelle est monté le composant de génération de chaleur (T), et
la pièce arrière (12) recouvre la surface arrière du substrat (P) à l'opposé de la surface sur laquelle est monté le composant de génération de chaleur (T).

3. Dispositif électronique doté de la structure auxiliaire d'assemblage (1, 10) selon la revendication 2, dans lequel
une première plaque latérale et une seconde plaque latérale sont disposées au niveau de deux extrémités opposées du substrat (P), la première plaque latérale et la seconde plaque latérale se faisant face,
une première partie de pliage (121) est formée par pliage et étendue d'une partie d'extrémité de la pièce arrière (12) en direction de la surface du substrat (P), la partie d'extrémité de la pièce arrière (12) est située dans le côté de la première plaque latérale, et des parties griffes conçues pour coopérer avec la première plaque latérale sont formées sur la première partie de pliage (121),
une deuxième partie de pliage (122) est formée par pliage et étendue d'une partie d'extrémité de la pièce arrière (12) en direction de la surface du substrat (P), la partie d'extrémité de la pièce arrière (12) est située dans le côté de la seconde plaque latérale, l'extrémité étendue de la deuxième partie de pliage est en outre pliée dans une direction parallèle à la surface du substrat (P) et étendue pour former une troisième partie de pliage (123), la troisième partie de pliage (123) est reliée à la pièce avant (11), et la partie de liaison de pièces avant et arrière est formée par la deuxième partie de pliage et par la troisième partie de pliage (123), et
une partie découpée intérieurement (105) conçue pour coopérer avec une partie découpée extérieurement formée sur la seconde plaque latérale est formée au niveau d'une position de la troisième partie de pliage (123) correspondant à la seconde plaque latérale.

4. Dispositif électronique doté de la structure auxiliaire d'assemblage (1, 10) selon l'une quelconque des revendications 1 à 4, dans lequel
la feuille de dissipation de chaleur (S) est disposée sur la partie des broches de montage (T2) qui fait face au boîtier (C), et la feuille de recouvrement (1, 10) recouvre la surface arrière du substrat (P) située à l'opposé de la surface sur laquelle est monté le composant de génération de chaleur (T).

5. Dispositif électronique doté de la structure auxiliaire d'assemblage (1, 10) selon la revendication 4, dans lequel
une première plaque latérale et une seconde plaque latérale sont disposées au niveau de deux extrémités du substrat (P), la première plaque latérale et la seconde plaque latérale se faisant face ;
une première partie de pliage (121) est formée par pliage et étendue d'une partie d'extrémité de la feuille de recouvrement (1, 10) en direction de la surface du substrat (P), la partie d'extrémité de la feuille de recouvrement (1, 10) est située dans le côté de la première plaque latérale, des parties griffes conçues pour coopérer avec la première plaque latérale sont formées sur la première partie de pliage (121), et
une deuxième partie de pliage (122) est formée par pliage et étendue d'une partie d'extrémité de la feuille de recouvrement (1, 10) en direction de la surface du substrat (P), la partie d'extrémité de la feuille de recouvrement (1, 10) est située dans le côté de la seconde plaque latérale, et une partie découpée intérieurement (105) conçue pour coopérer avec une partie découpée extérieurement formée sur le substrat (P) est formée sur la deuxième partie de pliage (122).

6. Dispositif électronique doté de la structure auxiliaire d'assemblage (1, 10) selon les revendications 1 à 5, dans lequel
la feuille de recouvrement (1, 10) est une feuille isolante.

7. Dispositif électronique doté de la structure auxiliaire d'assemblage (1, 10) selon les revendications 1 à 5, dans lequel
le dispositif électronique est un dispositif d'alimentation à découpage et le composant de génération de chaleur (T) est un transformateur.
